# FASCICULE DE BREVET EUROPEEN

(11) **EP 0 537 049 B1**
(45) Date de publication et mention de la délivrance du brevet: **13.09.1995**
(21) Numéro de dépôt: 92402661.0
(22) Date de dépôt: 29.09.1992
(51) Int. Cl.: C30B 25/18, C30B 25/02, H01L 21/20

(54) **Procédé de croissance de couches hétéroépitaxiales**
Verfahren zur Züchtung von heteroepitaktischen Schichten
Process for the growth of heteroepitaxial layers

(30) Priorité: 08.10.1991 FR 9112352
(43) Date de publication de la demande: 14.04.1993
(73) Titulaire: THOMSON-CSF, 75008 Paris (FR)
(72) Inventeur: Pribat, Didier, F-92045 Paris La Defense (FR); Gerard, Bruno, F-92045 Paris La Defense (FR); Legagneux, Pierre, F-92045 Paris La Defense (FR)
(74) Mandataire: Guérin, Michel

(56) Documents cités:
- EP-A- 0 336 830
- EP-A- 0 336 831
- EP-A- 0 380 815
- FR-A- 2 667 617

## Description

L'invention concerne un procédé de réalisation de couches hétéroépitaxiales plus précisément un procédé de réalisation d'au moins une couche mince d'un matériau semiconducteur sur un substrat semiconducteur d'un type différent.

L'invention a trait au domaine des "couches minces" et particulièrement au domaine des couches minces monocristallines épitaxiées sur un substrat de nature différente.

L'invention sera par exemple appliquée à la croissance de couches GaAs ou InP sur Si, et elle permet d'éliminer par blocage les dislocations générées à l'interface cristal/substrat.

Lors de la croissance hétéroépitaxiale de GaAs sur Si, des dislocations sont générées à l'interface cristal/substrat, qui se propagent dans la couche mince au cours du dépôt. De façon très schématique, la présence de ces dislocations est due à la fois à la différence entre les paramètres de maille de Si (0,54 nm) et GaAs (0,56 nm) et à la différence entre les coefficients d'expansion thermique (2,3 10⁻⁶.°C⁻¹ pour Si contre 5,6 10⁻¹⁰°C⁻¹ pour GaAs).

Ces dislocations une fois nucléées sont pratiquement impossible à éliminer au cours d'une croissance normale de type MBE ou MOCVD, ce qui limite considérablement le champ d'application des hétéroépitaxies de GaAs sur Si.

En effet, les dislocations, agissant comme des centres de recombinaison, diminuent de façon drastique la durée de vie des porteurs minoritaires. Il en résulte qu'il est pratiquement impossible de réaliser dans les couches hétéroépitaxiées de GaAs sur Si des composants de type bipolaires tels que lasers et photodiodes par exemple.

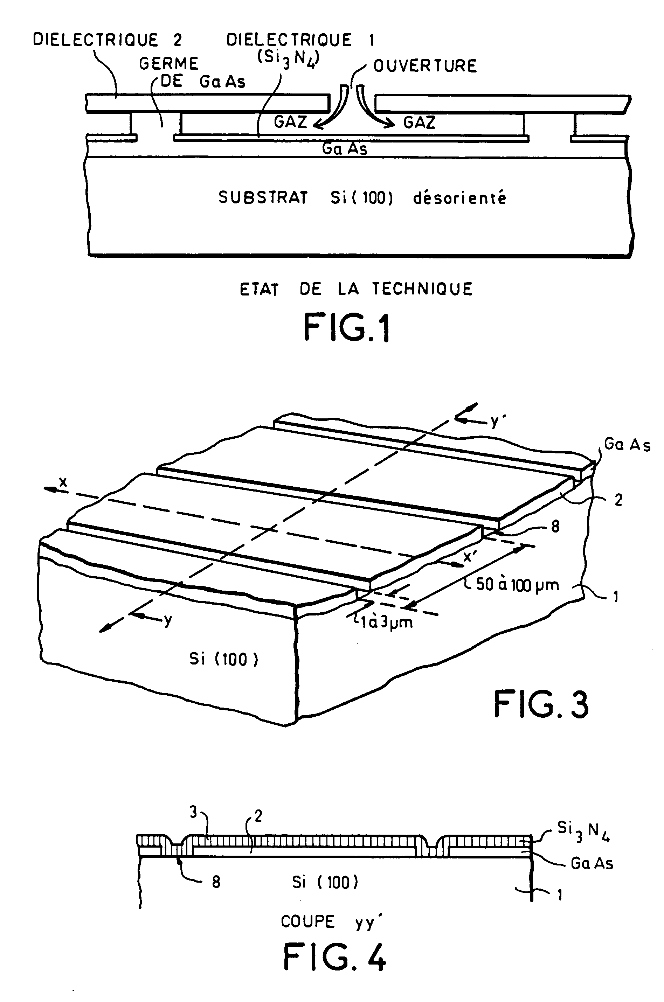

Un procédé de blocage des dislocations a été mis au point (voir FR-A-2 629 637). Ce procédé permet d'obtenir des couches pratiquement exemptes de défauts. Le principe de ce procédé (dit de croissance forcée) est représenté sur la figure 1. Un des inconvénients du procédé est qu'il nécessite l'utilisation de deux niveaux de diélectrique et de deux niveaux de masquage pour réaliser les bandes de germination d'une part, et les bandes permettant l'accès du gaz de la phase d'épitaxie forcée d'autre part (voir figure 1).

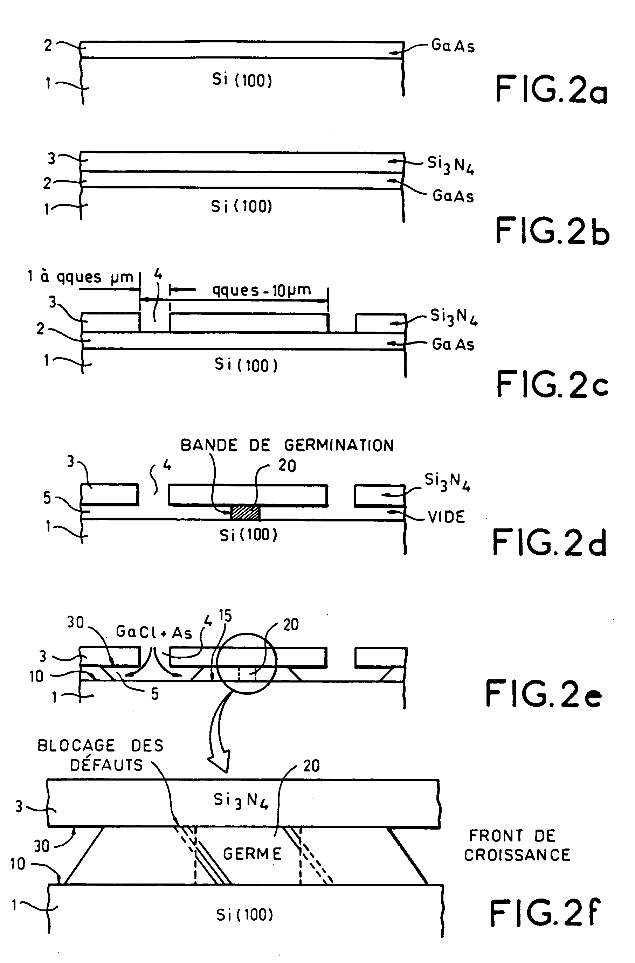

Le procédé décrit dans FR-A-2 667 617 permet de ne prévoir qu'un seul niveau de masquage. Les figures 2a à 2f représentent un procédé de réalisation décrit dans cette demande de brevet. Selon ce procédé, il s'agit, par exemple de réaliser une couche monocristalline de GaAs sans défauts sur silicium. On réalise donc tout d'abord une couche 2 de GaAs sur le substrat de silicium (figure 2a).

On recouvre la couche de GaAs par une couche 3 de Si₃N₄ (figure 2b). On grave des ouvertures 4 dans la couche de Si₃N₄ (figure 2c). Par ces ouvertures, on réalise une attaque chimique sélective du GaAs jusqu'à ne laisser qu'un germe 20 de GaAs représenté en hachures sur la figure 2d. Enfin, on fait croître du GaAs par épitaxie en phase vapeur à partir du germe de GaAs entre le substrat de silicium et le Si₃N₄ (figures 2e et 2f). Les dislocations sont bloquées sur le substrat ou sur la couche de Si₃N₄ (figure 2f).

Selon une variante du procédé décrit dans FR-A-2 667 617, après réalisation de la couche 2 de GaAs on grave des bandes 8 (figure 3) puis on recouvre l'ensemble d'une couche 3 de Si₃N₄ (figure 4). Ensuite, on grave à nouveau des bandes 9 dans la couche 3 perpendiculairement aux bandes précédentes 8 (figure 5).

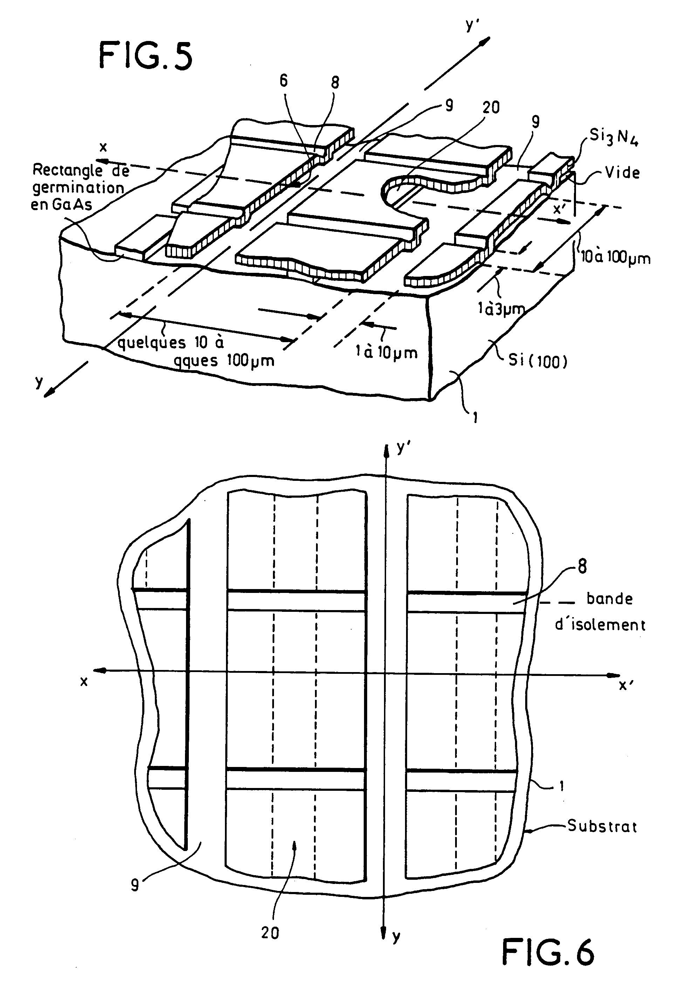

Par des ouvertures 6 faites à l'aide de la gravure en bandes 9, on pratique l'attaque sélective du GaAs jusqu'à laisser des germes 20 (figure 5). Enfin on réalise l'épitaxie en phase vapeur de GaAs et on obtient des pavés de GaAs sur silicium (figure 6) dont on peut prédéterminer les dimensions lors de la réalisation des bandes gravées 8 et 9.

Ce procédé permet ainsi de réaliser des croissances avec des semiconducteurs de nature différentes et d'obtenir des structures hétéroépitaxiales dans lesquelles les différentes couches sont néanmoins monocristallines et ne présentent pas de dislocation ni de plans de défauts. De plus, ce procédé permet de diminuer les contraintes de refroidissement dues aux différences de coefficients de dilatation thermique entre GaAs et Si.

Ce procédé prévoit d'utiliser la surface du substrat d'origine comme l'une des surfaces de confinement de la croissance latérale dirigée. La technique s'en trouve grandement simplifiée, car elle ne nécessite plus que la mise en oeuvre d'une seule étape de dépôt (dépôt de Si₃N₄ supérieur) et d une seule étape d'épitaxie sélective (l'étape de croissance forcée elle-même).

Cependant, dans ce procédé, des problèmes peuvent apparaître lors de la croissance en phase vapeur, particulièrement lorsque l'une des directions yy' ou xx' (figure 5) correspond à une direction cristallographique de type 〈011〉 du plan (100) du substrat. On constate en effet l'apparition de facettes latérales qui empêchent la croissance de se dérouler normalement.

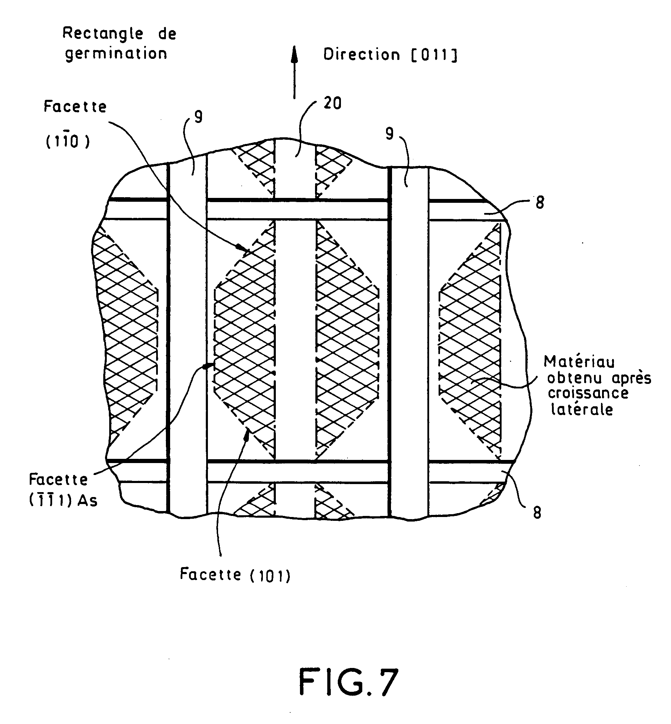

La figure 7 illustre cette situation en vue de dessus. Les bandes de germination 20 sont orientées selon la direction 〈011〉 du plan (100) du substrat et les facettes apparaissant après croissance sont indexées sur la figure 7. Le phénomène est gênant, car il permet difficilement l'obtention de pavés de forme rectangulaire après croissance.

La présente invention a pour objet de pallier cet inconvénient.

L'invention concerne donc un procédé de réalisation par croissance en phase vapeur sur un substrat en matériau semiconducteur d'un premier type d'une couche mince monocristalline d'un matériau semiconducteur d'un deuxième type selon lequel la croissance est initiée sur au moins un germe de composition chimique identique au matériau semiconducteur du deuxième type de la couche mince à obtenir, et est confinée dans un espace défini par une face du substrat 1 lui-même et une couche de confinement en matériau différent du matériau semiconducteur du deuxième type de telle façon qu'il ne peut y avoir ni nucléation ni dépôt de matériau semiconducteur sur cette couche de confinement ni sur ladite face du substrat, caractérisé en ce que la section droite du germe sensiblement perpendiculaire à la direction globale de croissance possède une partie centrale (21) épaisse et deux parties latérales (22, 23) amincies et que l'espace défini par le substrat (1) et la couche de confinement (3) présente une section droite de même profil que celle du germe.

En outre, l'invention concerne un procédé comme revendiqué dans la revendication 3 et les variantes de ce procédé sont revendiqué es dans les revendications dependantes.

Les différents objets et caractéristiques de l'invention apparaîtront plus clairement dans la description qui va suivre et dans les figures annexées qui représentent :
- les figures 1 à 7, des procédés de croissances connus dans la technique et décrits précédemment ;

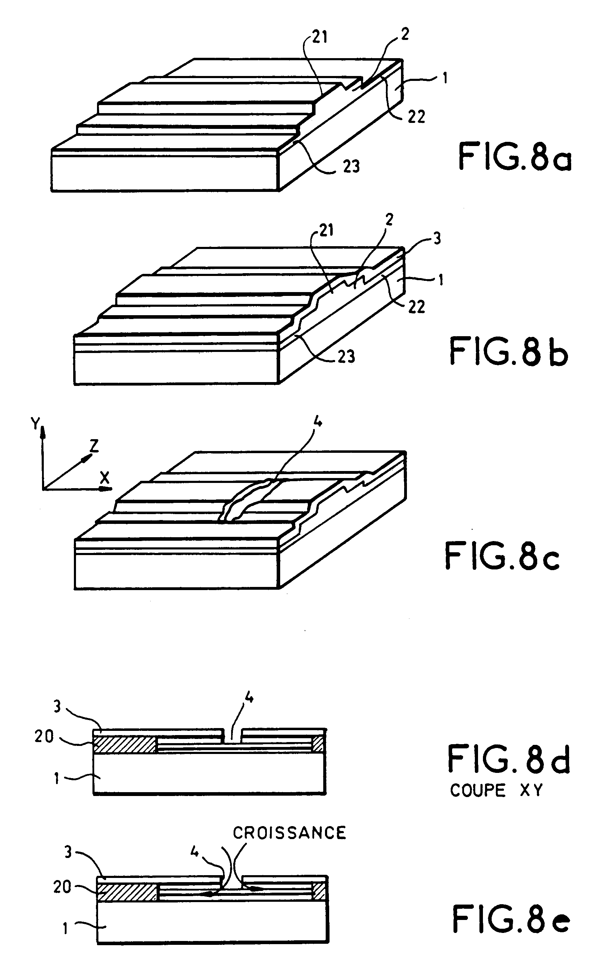

- les figures 8a à 8e, un procédé général de réalisation selon l'invention ;

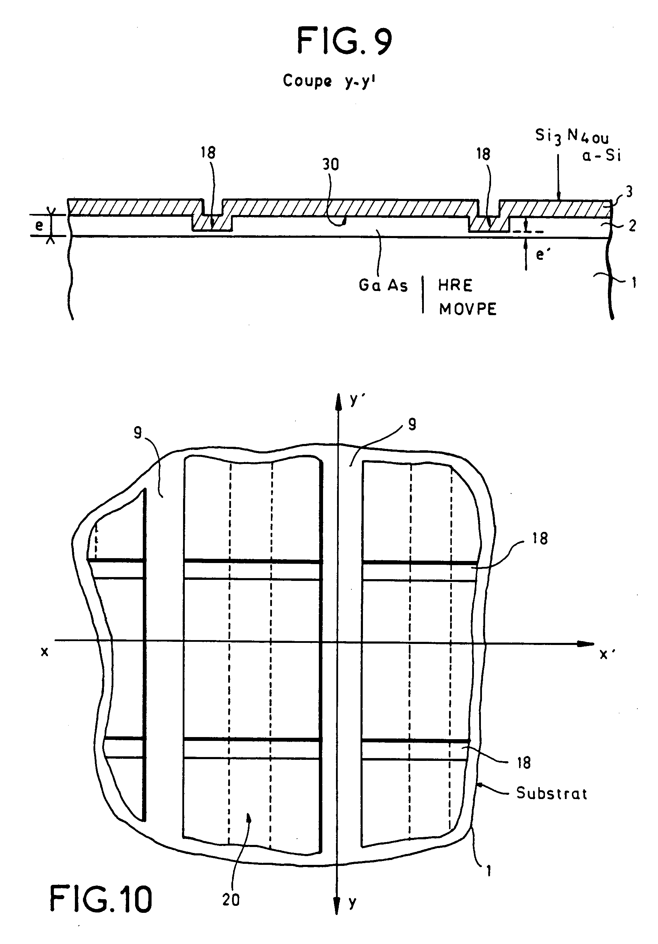

- les figures 9 et 10, un procédé plus détaillé conforme à l'invention ;

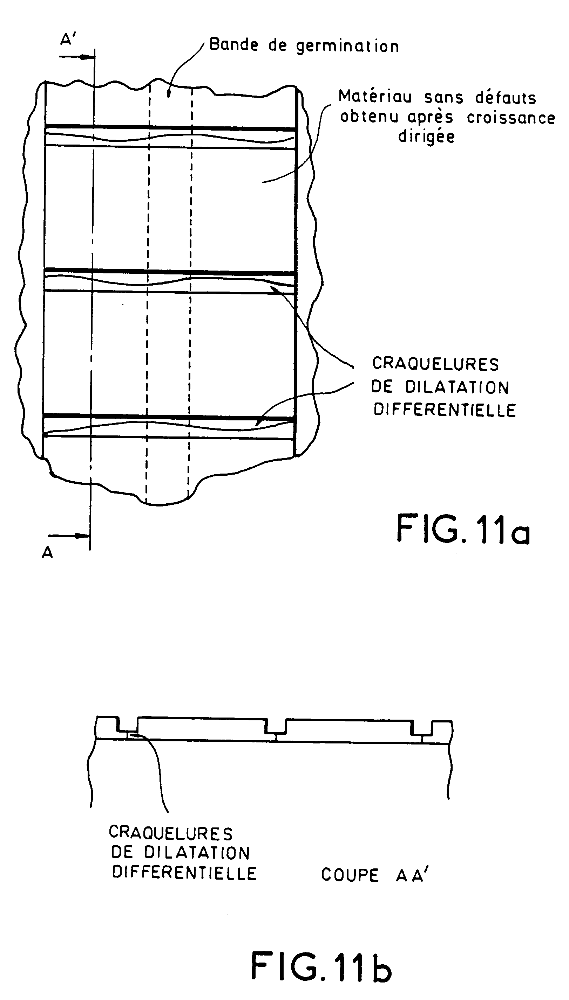

- les figures 11a et 11b, un dispositif obtenu par le procédé selon l'invention.

L'invention sera décrite en s'appuyant sur l'exemple de GaAs hétéroépitaxié sur Si, mais son cadre d'application est beaucoup plus large ; il suffit en effet pour pouvoir appliquer la présente méthode au cas de l'hétéroépitaxie d'un matériau A sur un matériau B, d'utiliser une méthode de dépôt permettant de supprimer (au moins temporairement) la nucléation de A sur B ou de prévoir un matériau B sur lequel il ne puisse y avoir ni nucléation, ni dépôt du matériau A.

L'invention sera donc mieux comprise à la lecture de la description qui va suivre.

On réalise sur un substrat 1 de départ, en silicium (100) une couche mince 2 de GaAs (épaisseur 0,5 à 1 µm typiquement). Cette couche 2 présente une partie centrale 21 avec de part et d'autre deux parties amincies 22 et 23. Cette partie amincie peut comporter, comme cela est représenté en figure 8a, différentes épaisseurs de façon à avoir une diminution graduelle (en escalier par exemple) de la couche de part et d'autre de la partie centrale 21.

Il n'est pas forcément nécessaire d'utiliser une plaquette légèrement désorientée vers la direction 〈110〉, car les défauts de type parois d'antiphase seront aussi bloqués. Cette opération préliminaire d'hétéroépitaxie peut s'effectuer par MBE (Molecular Beam Epitaxy), par MOCVD (Metal Organic Chemical Vapor Deposition), par MOMBE (Metal Organic Molecular Beam Epitaxy), par CBE (Chemical Beam Epitaxy) etc ...

On sait (voir par exemple l'article de revue de H. KROEMER dans l'ouvrage : "Heteroepitaxy on Silicon" édité par FAN et POATE, MRS Symposia Proceedings n° 67, Pittsburgh PA, 1986) que les couches de GaAs réalisées par des procédés tels que ceux cités ci-dessus contiennent dans le meilleur des cas environ 10⁶ dislocations par cm². Elles peuvent aussi contenir des micromacles et des parois d'antiphase selon les conditions de croissance. Il est bien sûr impossible de fabriquer des lasers et des photodiodes dans des couches comprenant une telle densité de défauts.

On dispose, sur la couche 2 de GaAs, une couche uniforme 3 de Si₃N₄ d'épaisseur typiquement de l'ordre de 0,3 à 0,9 µm (figure 8b). On a choisi le Si₃N₄ dans cet exemple de réalisation mais ce pourrait être tout autre matériau sur lequel il ne pourra y avoir ni nucléation, ni dépôt du matériau (GaAs selon l'exemple pris) qui va être épitaxié dans ce qui va suivre.

On grave dans cette couche 3 de Si₃N₄ au moins une ouverture 4 (figure 8c) aboutissant au moins au-dessus de la partie centrale du germe.

Comme cela est représenté en figure 8d, on procède, par l'ouverture 4, à l'attaque de la couche 2 de façon à conserver un germe 20.

Ensuite, on réalise une croissance (figure 8e) à l'aide d'un même matériau que celui constituant le germe 20 et la croissance (en phase vapeur) s'effectue à partir du germe 20 entre la couche 3 et le substrat 1.

Le profil global de la section droite du germe 20 sensiblement perpendiculaire à la direction de croissance xx' présente une partie épaisse 21 avec de part et d'autre des parties amincies 22, 23. La croissance s'effectue alors globalement perpendiculairement à la section droite du germe.

En se reportant aux figures 9 et 10, on va maintenant décrire un exemple détaillé du procédé de l'invention.

On réalise tout d'abord sur un substrat 1 en matériau semiconducteur d'un premier type, une couche 2 d'un matériau semiconducteur d'un deuxième type. Par exemple, le substrat 1 est en silicium et la couche 2 en GaAs.

Ensuite, on grave des bandes d'amincissement 18 dans la couche 2 (GaAs) hétéroépitaxiée sur le substrat. Ces bandes ne mettent pas à nu le substrat de silicium.

Le pas de répétition de ces bandes d'amincissement est par exemple de 50 à 100 µm et la largeur de ces bandes est typiquement de 1 à quelques microns. Ces bandes sont orientées selon une direction 〈110〉 ou 〈110〉 (selon xx' sur la figure 3). L'épaisseur e de la couche 2 est par exemple de 0,5 à 3 µm tandis que l'épaisseur e' des amincissements 18 est par exemple de l'ordre de 0,05 à 0,2 µm.

On dépose ensuite la couche 3 de Si₃N₄ sur la surface précédemment gravée. La figure 9 représente une coupe selon yy' après dépôt de cette couche 3 de Si₃N₄.

L'épaisseur typique de la couche 3 de Si₃N₄ est de 0,5 à 1 µm.

On grave ensuite dans la couche 3 de Si₃N₄ un deuxième système de bandes 9, qui peut être de préférence perpendiculaire aux premières bandes 18, c'est-à-dire perpendiculaire aux gravures 18 comme cela est représenté en figure 10.

Ces bandes font typiquement de 1 à 10 µm de largeur et leur pas de répétition est de quelques dizaines à quelques centaines de microns.

On immerge ensuite la structure obtenue dans un réactif d'attaque chimique du matériau de la couche 2. Par exemple, un mélange de H₂O₂ et H₂SO₄ convient pour éliminer de manière sélective une partie de la couche mince 2 de GaAs hétéroépitaxiée. Cependant on arrête l'attaque de la couche 2 de façon à conserver une partie centrale 20 (figure 10) qui sert de support à la couche 3 de Si₃N₄ et qui va servir de germe lors de l'opération de croissance qui va suivre.

Il en résulte qu'après la gravure chimique de la couche de GaAs (sous la couche 2) permettant de dépasser les zones de germination, on obtient non plus des rectangles, mais des bandes continues dont l'épaisseur diminue de façon périodique.

La figure 10 représente une vue de dessus de la structure après définition des bandes de germination. De toute façon, les bandes de germination ne soit pas discontinues et, lors de l'opération de croissance dirigée, le front latéral de croissance n'est plus interrompu.

On introduit ensuite la structure obtenue dans un réacteur par exemple de type VPE utilisant comme sources de l'AsCl₃ et du Ga dans le cas de croissance de GaAs. Dans des conditions normales de dépôt, c'est-à-dire lorsque la source de Ga est maintenue vers 850°C, que la fraction molaire de As Cl₃ est de l'ordre de 10⁻³ et que le substrat est maintenu aux alentours de 750°C, on constate qu'il y a nucléation et croissance de GaAs sur le germe central 20, mais par contre on n'observe ni nucléation ni croissance à la fois sur les surfaces exposées de la couche 3 de Si₃N₄, ni sur le substrat 1 en Si (100).

On peut obtenir un effet similaire de croissance sélective en utilisant un réacteur de type MOCVD avec des précurseurs non plus de la forme triethyl ou trimethyl gallium, mais incorporant des chlorures, c'est-à-dire des précurseurs tels que diethylgallium chlorure (C₂H₅)₂ GaCl (voir par exemple le document KUECH et all. Proceeding of the 5th International Conference on MOVPE, AACHEN, Germany 18-22 juin 1990).

La croissance à partir du germe central 20 de GaAs s'effectue entre la surface du substrat Si (100) et la surface inférieure de la couche 3 de Si₃N₄, sans qu'il y ait nucléation sur Si ni sur Si₃N₄.

On observe ici un phénomène de blocage de tous les défauts qui ne sont pas strictement parallèles aux interfaces GaAs/Si₃N₄ (dislocations, micromacles et parois d'antiphase). Ce biocage s'effectue soit sur la face inférieure 30 de la couche 3 (figure 9), soit sur la surface du substrat 1 en Si (100). Une fois les défauts bloqués, la croissance se poursuit normalement de part et d'autre du germe central 20, le cristal obtenu étant alors d'excellente qualité.

Au cours d'une étape suivante on enlève ensuite la couche 3 et on obtient des éléments en semiconducteur en GaAs en couches minces sur un substrat silicium.

Une variante de la technique consiste à introduire directement dans le réacteur d'épitaxie la structure après réalisation des gravures 9. L'attaque de la couche 2 en GaAs à travers les ouvertures des gravures 9 pratiquées dans la couche 3 de Si₃N₄ s'effectue alors in situ, par du gaz chlorhydrique HCl, soit généré par décomposition de AsCl₃ dans le cas d'un réacteur trichlorure (il faut alors disposer d'une ligne d'AsCl₃ supplémentaire, ne transitant pas par la charge de Ga) soit directement injecté à partir d'une bouteille dans le cas d'un réacteur MOCVD.

On obtient ainsi après croissance forcée et retrait de la couche 3 des pavés de GaAs sans défauts hormis la zone centrale de germination 20 (figure 10). Le germe 20 et la bande de défauts peuvent être éliminés par gravure.

On peut également avant le retrait de la couche 3, réaliser dans la couche 3, une gravure de bandes selon une direction yy', de façon à pratiquer une ouverture au dessus de chaque germe 20.

Ensuite, on réalise une attaque chimique des germes 20 et des parties défectueuses de semiconducteur. Puis on effectue une épitaxie du même matériau (GaAs). On enlève la couche de Si₃N₄ et on obtient des pavés de matériau semiconducteur sans défaut.

On peut ensuite éventuellement effectuer une croissance de matériau semiconducteur (GaAs) sur les pavés de façon à réunir deux pavés.

Comme on l'a vu précédemment, la croissance de GaAs entre la couche 3 et le substrat 1 se fait à partir d'un germe qui présente des amincissements mais qui n'est pas interrompu. Le front de croissance n'est donc pas l'on plus interrompu, ce qui a pour effet de supprimer le facettage précédemment observé tel que décrit en relation avec la figure 7. De plus, l'épaisseur du germe 20 étant localement plus faible, et de façon périodique les contraintes de contraction (dues à la différence entre les coefficients de dilatation du GaAs et du substrat) apparaissant lors du refroidissement (après croissance forcée) seront localisées dans les régions de faible épaisseur qui sont les plus fragiles. De même, si des craquelures apparaissent, elles seront ainsi localisées dans ces mêmes régions de faible épaisseur si la période des régions en question est adaptée.

En résumé l'invention permet de localiser les zones défectueuses après croissance ; les figures 11a et 11b résument cette situation après élimination de la couche d'encapsulation.

Il est bien évident que la description qui précède n'a été faite qu'à titre d'exemple non limitatif. D'autres variantes peuvent être envisagées sans sortir du cadre de l'invention. Les valeurs numériques n'ont été fournies uniquement que pour illustrer la description. Par ailleurs, comme cela a déjà été mentionné l'application de l'invention à une structure à base de semiconducteurs indiqués dans la description n'a été fournie qu'à titre d'exemple et d'autre matériaux que le silicium ou le GaAs pourraient être utilisés ; dans ce cas la solution chimique utilisée pour l'élimination partielle de la couche 2 devra être adaptée au matériau de cette couche 2. Egalement, les procédés de gravure et de croissance peuvent être différents de ceux indiqués précédemment.

## Revendications

1. Procédé de réalisation par croissance en phase vapeur, sur un substrat en matériau semiconducteur d'un premier type, d'une couche mince monocristalline d'un matériau semiconducteur d'un deuxième type selon lequel la croissance est initiée sur au moins un germe (20) de composition chimique identique au matériau semiconducteur du deuxième type de la couche mince à obtenir, et est confinée par un espace défini par une face du substrat (1) lui-même et une couche de confinement (3) en matériau différent du matériau semiconducteur du deuxième type de telle façon qu'il ne peut y avoir ni nucléation ni dépôt de matériau semiconducteur sur cette couche de confinement (3) ni sur ladite face du substrat (1), caractérisé en ce que la section droite du germe sensiblement perpendiculaire à la direction globale de croissance possède une partie centrale (21) épaisse et deux parties latérales (22, 23) amincies et que l'espace défini par le substrat (1) et la couche de confinement (3) présente une section droite de même profil que celle du germe (20).

2. Procédé de réalisation selon la revendication 1, caractérisé en ce que le germe (20) est compris dans l'espace de confinement (5).

3. Procédé de croissance de couches hétéroépitaxiales caractérisé en ce qu'il comporte les étapes suivantes :
a) une première étape de réalisation sur un substrat (1) semiconducteur monocristallin d'un premier type d'une première couche (2) d'un matériau semiconducteur d'un deuxième type ;
b) une deuxième étape de gravure dans la première couche (2) de façon à réaliser une structure allongée selon une direction (X) et dont la section perpendiculaire à cette direction présente différentes épaisseurs avec une partie centrale épaisse encadrée par des parties moins épaisses;
c) une troisième étape de réalisation sur la première couche (2) d'une couche de confinement (3) en matériau tel qu'il ne peut y avoir ni nucléation, ni dépôt d'un matériau du deuxième type ;
d) une quatrième étape de gravure dans la deuxième couche (3) d'au moins une première ouverture (4, 9) aboutissant au-dessus de la partie centrale de la première couche de matériau semiconducteur (2) ;
e) une cinquième étape d'attaque chimique à partir de ladite ouverture de la première couche (2) de matériau semiconducteur de façon à laisser au moins un germe (20) de matériau semiconducteur du deuxième type entre la deuxième couche (3) et le substrat (1) et à constituer un espace de confinement (5) ;
f) une sixième étape de croissance par épitaxie en phase vapeur d'un matériau semiconducteur monocristallin du deuxième type dans l'espace de confinement (5), cette croissance étant réalisée selon une première direction de croissance.

4. Procédé selon la revendication 3, caractérisé en ce qu'il comporte une septième étape de retrait de la couche de confinement (3).

5. Procédé selon la revendication 3, caractérisé en ce que la sixième étape de croissance par épitaxie en phase vapeur est suivie d'une étape de gravure d'au moins une deuxième ouverture dans la deuxième couche (3) à un emplacement situé au-dessus du germe (20), puis d'une étape d'attaque chimique par la deuxième ouverture réalisée, du germe (20) et de toute partie de matériau semiconducteur située de part et d'autre du germe (20) et présentant des défauts.

6. Procédé selon la revendication 5, caractérisé en ce qu'il comporte, à la suite des étapes suivantes, une étape d'épitaxie en phase vapeur d'un matériau du deuxième type par la deuxième ouverture.

7. Procédé selon la revendication 6, caractérisé en ce qu'il comporte à la suite de l'étape indiquée, une étape d'enlèvement de la deuxième couche (3) suivie d'une étape d'épitaxie en phase vapeur d'un matériau du deuxième type.

8. Procédé selon la revendication 3, caractérisé en ce que la première ouverture (9) réalisée lors de la quatrième étape de gravure se présente sous une forme linéaire qui n'est pas parallèle à la structure allongée pratiquée dans la première couche (2).

9. Procédé selon la revendication 8, caractérisé en ce la première ouverture (9) est perpendiculaire à la structure allongée pratiquée dans la première couche (2).

## Claims

1. Process for producing, by vapour phase growth on a substrate made of semiconductor material of a first type, a thin monocrystalline layer of a semiconductor material of a second type, in which process the growth is initiated on at least one seed (20) of chemical composition identical to the semiconductor material of the second type of the thin layer to be obtained and is confined by a space defined by one face of the substrate (1) itself and a confinement layer (3) made of material different from the semiconductor material of the second type, so that there is no possibility of there being either nucleation or deposition of semiconductor material on this confinement layer (3) or on the said face of the substrate (1), characterized in that the cross-section of the seed substantially perpendicular to the overall growth direction possesses a thick central part (21) and two thinned lateral parts (22, 23) and in that the space defined by the substrate (1) and the confinement layer (3) has a cross-section of the same profile as that of the seed (20).

2. Production process according to Claim 1, characterized in that the seed (20) lies in the confinement space (5).

3. Process for growing heteroepitaxial layers, characterized in that it comprises the following steps:
a) a first step of producing, on a monocrystalline semiconductor substrate (1) of a first type, a first layer (2) of a semiconductor material of a second type;
b) a second step of etching in the first layer (2) so as to produce a structure which is elongate in a direction (X) and the cross-section of which, perpendicular to this direction, has different thicknesses with a thick central part flanked by thinner parts;
c) a third step of producing, on the first layer (2), a confinement layer (3) made of material such that there is no possibility of there being either nucleation or deposition of a material of the second type;
d) a fourth step of etching, in the second layer (3), at least one first opening (4, 9) terminating above the central part of the first layer of semiconductor material (2);
e) a fifth step of chemical etching, starting from the said opening, of the first layer (2) of semiconductor material so as to leave at least one seed (20) of semiconductor material of the second type between the second layer (3) and the substrate (1) and to form a confinement space (5);
f) a sixth step of growing, by vapour phase epitaxy, a monocrystalline semiconductor material of the second type in the confinement space (5), this growth taking place along a first growth direction.

4. Process according to Claim 3, characterized in that it comprises a seventh step of removing the confinement layer (3).

5. Process according to Claim 3, characterized in that the sixth step, of growth by vapour phase epitaxy, is followed by a step of etching at least one second opening in the second layer (3) at a place located above the seed (20) and then a step of chemical etching, via the second opening produced, of the seed (20) and any part of semiconductor material lying on either side of the seed (20) and exhibiting defects.

6. Process according to Claim 5, characterized in that it comprises, after the following steps, a step of vapour phase epitaxy of a material of the second type via the second opening.

7. Process according to Claim 6, characterized in that it comprises, after the step indicated, a step of removal of the second layer (3) followed by a step of vapour phase epitaxy of a material of the second type.

8. Process according to Claim 3, characterized in that the first opening (9) produced during the fourth, etching, step is in a linear form which is not parallel to the elongate structure made in the first layer (2).

9. Process according to Claim 8, characterized in that the first opening (9) is perpendicular to the elongate structure made in the first layer (2).

## Patentansprüche

1. Verfahren zur Bildung einer einkristallinen Dünnschicht aus einem Halbleitermaterial eines zweiten Typs auf einem Substrat aus Halbleitermaterial eines ersten Typs durch Wachstum aus der Dampfphase, bei dem das Wachstum auf wenigstens einem Keim (20) eingeleitet wird, dessen chemische Zusammensetzung mit dem Halbleitermaterial des zweiten Typs der zu erhaltenden Dünnschicht identisch ist, und durch einen Raum begrenzt ist, der definiert ist durch eine Fläche des Substrats (1) selbst und durch eine Einschlußschicht (3) aus einem Material, das von dem Halbleitermaterial des zweiten Typs verschieden ist, derart, daß weder eine Nukleation noch ein Absetzen von Halbleitermaterial auf dieser Einschlußschicht (3) oder auf der Fläche des Substrats (1) stattfinden kann, dadurch gekennzeichnet, daß der Querschnitt des Keims im wesentlichen senkrecht zu der globalen Wachstumsrichtung einen dicken mittleren Teil (21) und zwei dünnere seitliche Teile (22, 23) besitzt und daß der von dem Substrat (1) und der Einschlußschicht (3) definierte Raum einen Querschnitt mit dem gleichen Profil wie derjenige des Keims (20) aufweist.

2. Verfahren zur Bildung gemäß Anspruch 1, dadurch gekennzeichnet, daß der Keim (20) in dem Einschlußraum (5) enthalten ist.

3. Verfahren zur Züchtung von heteroepitaktischen Schichten, dadurch gekennzeichnet, daß es die folgenden Schritte enthält:
(a) einen ersten Schritt, in welchem auf einem einkristallinen Halbleitersubstrat (1) eines ersten Typs eine erste Schicht (2) aus einem Halbleitermaterial eines zweiten Typs gebildet wird;
(b) einen zweiten Schritt, in welchem in der ersten Schicht (2) in der Weise geätzt wird, daß eine in einer Richtung (X) langgestreckte Struktur gebildet wird, deren Querschnitt senkrecht zu dieser Richtung verschiedene Dicken aufweist, mit einem dicken mittleren Teil, der von weniger dicken Teilen eingerahmt ist;
(c) einen dritten Schritt, in welchem auf der ersten Schicht (2) eine Einschlußschicht (3) aus einem solchen Material gebildet wird, daß daran weder eine Nukleation noch ein Absetzen eines Materials des zweiten Typs stattfinden kann;
(d) einen vierten Schritt, in welchem in der zweiten Schicht (3) wenigstens eine erste Öffnung (4, 9) geätzt wird, die oberhalb des mittleren Teils der ersten Schicht (2) aus Halbleitermaterial endet;
(e) einen fünften Schritt, in welchem die erste Schicht (2) aus Halbleitermaterial ausgehend von der Öffnung derart geätzt wird, daß wenigstens ein Keim (20) aus Halbleitermaterial des zweiten Typs zwischen der zweiten Schicht (3) und dem Substrat (1) belassen wird und ein Einschlußraum (5) gebildet wird;
(f) einen sechsten Schritt, in welchem durch Epitaxie aus der Dampfphase ein einkristallines Halbleitermaterial des zweiten Typs in dem Einschlußraum (5) gezüchtet wird, wobei das Wachstum in einer ersten Wachstumsrichtung erfolgt.

4. Verfahren gemäß Anspruch 3, dadurch gekennzeichnet, daß es einen siebten Schritt des Entfernens der Einschlußschicht (3) enthält.

5. Verfahren gemäß Anspruch 3, dadurch gekennzeichnet, daß auf den sechsten Schritt des Wachstums durch Epitaxie aus der Dampfphase ein Schritt folgt, in welchem wenigstens eine zweite Öffnung in der zweiten Schicht (3) an einer Stelle geätzt wird, die oberhalb des Keims (20) liegt, und dann ein Schritt, in welchem durch die gebildete zweite Öffnung der Keim (20) und jeder zu beiden Seiten des Keims (20) liegende Teil des Halbleitermaterials, der Defekte aufweist, chemisch geätzt wird.

6. Verfahren gemäß Anspruch 5, dadurch gekennzeichnet, daß es im Anschluß an die folgenden Schritte einen Schritt der Epitaxie eines Materials des zweiten Typs aus der Dampfphase durch die zweite Öffnung enthält.

7. Verfahren gemäß Anspruch 6, dadurch gekennzeichnet, daß es im Anschluß an den angegebenen Schritt einen Schritt des Entfernens der zweiten Schicht (3) enthält, gefolgt von einem Schritt der Epitaxie eines Materials des zweiten Typs aus der Dampfphase.

8. Verfahren gemäß Anspruch 3, dadurch gekennzeichnet, daß die im vierten Schritt des Ätzens gebildete erste Öffnung (9) in einer linearen Form erscheint, die zu der in der ersten Schicht (2) gebildeten langgestreckten Struktur nicht parallel ist.

9. Verfahren gemäß Anspruch 8, dadurch gekennzeichnet, daß die erste Öffnung (9) senkrecht zu der in der ersten Schicht (2) gebildeten langgestreckten Struktur ist.
